# EUROPÄISCHE PATENTSCHRIFT

(11) **EP 0 811 262 B1**
(45) Veröffentlichungstag und Bekanntmachung des Hinweises auf die Patenterteilung: **16.05.2001**
(21) Anmeldenummer: 96902874.5
(22) Anmeldetag: 21.02.1996
(51) Int. Cl.: H01S 5/024, H01L 33/00, H01L 23/473

(54) **DIODENLASERBAUELEMENT MIT KÜHLELEMENT**
DIODE LASER COMPONENT WITH COOLING ELEMENT
COMPOSANT A DIODE LASER AVEC ELEMENT DE REFROIDISSEMENT

(30) Priorität: 22.02.1995 DE 19506093
(43) Veröffentlichungstag der Anmeldung: 10.12.1997
(73) Patentinhaber: DILAS DIODENLASER GMBH, 55129 Mainz (DE); Ullmann, Christoph, Dr., 53639 Königswinter (DE); Krause, Volker, 67292 Kirchheimbolanden (DE)
(72) Erfinder: ULLMANN, Christoph, D-53639 Königswinter (DE); KRAUSE, Volker, D-67292 Kirchheimbolanden (DE)
(74) Vertreter: Graf, Helmut, Dipl.-Ing.
(86) Internationale Anmeldenummer: DE9600265
(87) Internationale Veröffentlichungsnummer: WO9626560

(56) Entgegenhaltungen:
- EP-A- 0 508 717
- DE-A- 4 315 580
- US-A- 4 516 632
- US-A- 5 105 430
- PATENT ABSTRACTS OF JAPAN vol. 009, no. 131 (E-319), 6.Juni 1985 & JP,A,60 016431 (HITACHI DENSEN KK), 28.Januar 1985,

## Beschreibung

Die Erfindung bezieht sich auf ein Diodenlaserbauelement mit einem Kühlkörper gemäß dem Patentanspruch 1.

Ein Diodenlaserbauelement ist im Sinne der Erfindung eine Anordnung, die aus wenigstens einer Diodenlaseranorndung mit mehreren Diodenlasern oder Emittern sowie aus einem Kühlelement besteht. Zustäzlich können bei dem Diodenlaserbauelement auch weitere Bauelemente beispielsweise zur Ansteuerung des Diodenlasers oder der Diodenlaseranorndung vorgesehen sein.

Bekannt sind mehrschichtige Kühlanordnungen oder Kühlsysteme für elektrische und elektronische Bauelemente, insbesondere auch solche als Wärmesenke für Hochleistungs-Laserdioden oder Hochleistungs-Laserdiodenanordnungen (US 51 05 430).

Bei bekannten Kühlsystemen sind in dem stapelartig aneinander anschließenden Schichten Kühlkanäle ausgebildet, die von einem flüssigen Kühlmedium, beispielsweise Wasser durchströmt werden. Diese Kanäle sind bei den bekannten Systemen typischerweise Mikro-Kanäle, die in den Schichten in unmittelbarer Nähe des zu kühlenden Bauelementes durch dreidimensionale Mikro-Strukturen gebildet sind, um so durch eine möglichst große, mit dem Kühlmedium in Kontakt kommende Oberfläche eine Verbesserung der Kühlwirkung zu erreichen. Durch den Einsatz einer derartigen Wärmesenke kann der Wärmewiderstand gegenüber einem konventionellen konduktiven Kühler um einen Faktor 2-5 reduziert werden.

So ist beispielsweise eine Kühlanordnung mit einem zirkulierendem Kühlmedium zur Kühlung von Halbleiter-Diodenlaser bekannt (US 51 05 430), bei der das zu kühlende Bauelement sowohl elektrisch als auch thermisch mit dem Kühler verbunden ist. Unter dem Halbleiter-Bauelement sind die Mikro-Kanäle ausgebildet. Zum Zuführen und Abführen sind im Kühlelement Zu- und Abführkanäle ausgebildet.

Bekannt ist weiterhin eine Anordnung (US 50 99 910), bei der ein großflächiger Kühler durch eine Vielzahl von Mikro-Kanälen unter einer zu kühlenden Fläche erzeugt ist. Die Besonderheit bei dieser bekannten Anordnung besteht in der speziellen Form der mäanderförmigen Kühlmittelführung durch die Mikro-Kanäle. Die Anordnung eignet sich zum Kühlen von elektronischen Bauelementen allgemein.

Bekannt ist weiterhin eine Kühlanordnung (US 45 73 067), die speziell für kompakte integrierte Schaltkreise bestimmt ist. Zur Vergrößerung der Kühl- bzw. Wärmetauscherfläche werden Kühlstäbe verwendet, die in einer von dem Kühlmedium durchströmten Kammer untergebracht sind.

Bekannt ist schließlich auch eine als Kreuzstrom-Wärmeaustauscher ausgebildete Kühlanordnung (US 45 16 632), die aus mehreren, aufeinander gelegten, strukturierten Blechen besteht.

Nachteil ist bei den bekannten Diodenlaserbauelementen oder deren Kühlern, daß sie, soweit sie zur Erzielung einer möglichst effizienten Wärmeabfuhr Mikro-Kanäle verwenden, d.h. Kanäle mit einer Breite kleiner als 100 µm, eine relativ aufwendige Herstellung erfordern und daß darüberhinaus die unterschiedlichen Ausdehnungskoeffizienten des Kühlelementes und des Chipmaterials des zu kühlenden Bauelementes nicht berücksichtigt ist sowie auch die mechanische Festigkeit und die Möglichkeiten der Stromzuführung nicht optimal gelöst sind.

Bekannte Kühlelemente erfordern, sofern es sich hier um metallische und leitfähige Kühler handelt, zusätzliche isolierende Folien zur Isolation oder Potentialtrennung an den elektrischen Bauelementen, insbesondere auch zwischen Anode und Kathode eines Diodenlasers. Als zusätzliche Schwierigkeit ergibt sich hierbei auch, daß diese isolierende Folie, falls sie eine dichtende Funktion gegenüber dem Kühlmedium hat, durch den Druck des Kühlmediums verformt wird. Hierdurch sind dann Spannungen in dem zu kühlenden Halbleiter-Bauelement unvermeidlich, die zu einer frühzeitigen Schädigung des Halbleiter-Bauelementes, beispielsweise Halbleiter-Diodenchips führen.

Bei nichtleitenden Kühlern besteht die Notwendigkeit, leitfähige Schichten galvanisch aufzubringen, und zwar als Kontaktschichten und Leiterbahnen. Derartige galvanisch aufgebrachte Schichten verfügen aber in der Regel nur über sehr geringe Dicken, so daß große Ohm'sche Verluste auftreten und hohe Stromdichten in den leitenden Schichten nicht möglich sind, da diese zu einer metallurgischen Veränderung der leitenden Schichten, d.h. der Leiterbahnen und Kontaktflächen führen können.

Bei bekannten Kühlelementen wird versucht, durch entsprechende Materialauswahl den Ausdehnungskoeffizienten des Kühlelementes dem Ausdehnungskoeffizienten des Chipmaterials des Halbleiter-Bauelementes, beispielsweise dem Ausdehnungskoeffizienten von GaAs bei Halbleiter-Diodenlasern anzupassen. Die hierbei in Frage kommenden Materialien besitzen aber relativ geringe Wärmeleitfähigkeiten.

Nachteilig bei bekannten metallischen Kühlelementen, die aus dünnen Metallschichten oder Metallfolien bestehen ist, daß die Beständigkeit dieser Kühlelemente gegen mechanische Verformungen nicht sehr groß ist, d.h. während oder nach einem Montagevorgang sind Verformungen möglich, die dann zu Spannungen in den am Kühlelement vorgesehenen Halbleiter-Bauelement und damit zu einer Verringerung der Lebensdauer dieses Bauelementes führen.

Aufgabe der Erfindung ist es, ein Diodenlaserbauelement aufzuzeigen, welches bei der Möglichkeit einer einfachen Herstellung des Kühlelementes und optimaler Kühlwirkung die Nachteile der bekannten Diodenlaserbauelemente und deren Kühlelemente vermeidet.

Zur Lösung dieser Aufgabe ist ein Diodenlaserbauelement entsprechend dem Patentanspruche 1 ausgebildet.

Entsprechend einem ersten Aspekt der Erfindung gemäß Anspruch 1 geht es um die Schaffung eines Diodenlaserbauelementes, bei dem mechanische Spannungen, insbesondere auch thermisch bedingte mechanische Spannungen in der Laserdiodenanordnung oder in dem entsprechenden Chip vermieden sind (Spannungsfreiheit). Hierfür ist bei dem Diodenlaserbauelement bzw. deren Kühlelement dasjenige Material, welches einen im Vergleich zu dem Wärmeausdehnungskoeffizienten von Metall wesentlich kleineren Wärmeausdehnungskoeffizienten besitzt, in dem Mehrschichtmaterial so angeordner und der Anteil an diesem Material so groß gewählt, daß die thermische Festigkeit dieses Materials größer ist als die thermische Festigkeit der Metallschichten, d.h. die thermische Ausdehnung des Kühlelementes zumindest an der Montagefläche im wesentlichen nur durch die Schicht aus dem Material mit dem kleineren Wärmeausdehnungskoeffizienten bestimmt ist.

Weiterhin ist das erfindungsgemäße Kühlelement oder das Mehrfach-Substrat bevorzugt symmetrisch zu einer Mittelebene ausgebildet, so daß das Kühlelement trotz der verwendeten Metallschichten insgesamt einen reduzierten bzw. "gebremsten" Ausdehnungskoeffizienten besitzt, ohne daß sich das Kühlelement bei thermischen Wechselbelastungen verbiegt. Die von dem wärmetransportierenden Medium durchströmten Kanäle sind bei dem erfindungsgemäßen Kühlelement Makro-Kanäle, d.h. solche mit relativ großen Abmessungen, die preiswert gefertigt werden.

Diese Kanäle sind dann bevorzugt durch einfache Schlitze oder Ausnehmungen in einer Schicht realisiert. Diese Schlitze sind dann durch angrenzende Schichten zur Bildung des jeweiligen Kanales geschlossen. Die erforderliche Kühlwirkung wird dadurch erreicht, daß der Strömungsweg für das Kühlmedium wenigstens zwei derartige Kanäle in unterschiedlichen Ebenen des Mehrfach-Substrates aufweist, die durch eine Öffnung miteinander verbunden sind, so daß im Bereich dieser Öffnung die Strömung des Kühlmediums nicht nur umgelenkt wird, sondern im Bereich dieser Öffnung wenigstens eine angrenzende Schicht in einer Achsrichtung senkrecht zur Mittelebene des Kühlelementes von dem Kühlmedium angeströmt wird, so daß dort durch eine turbulente Strömung ein wesentlich verbesserter Wärmeübergang zwischen dem Kühlelement und dem Kühlmedium erreicht wird.

Durch die Makro-Struktur der Kanäle ist eine preiswerte Fertigung des erfindungsgemäßen Kühlelementes möglich, und zwar ohne eine Verschlechterung der Kühlwirkung, da durch den Aufprall des Kühlmediums an den zwei Kanäle verbindenden Öffnungen durch Turbulenz eine verbesserte Wärmeübertragung an das Kühlmedium erreicht wird.

Durch den symmetrischen Aufbau werden weiterhin auch ein Wölben des Kühlelementes bei wechselnden Temperaturen und damit zusätzliche Beanspruchungen des am Kühlelement vorgesehenen Diodenlaserelement vermieden. Durch die Auswahl der Anzahl der Schichten und/oder deren Dicke ist es weiterhin auch möglich, den Wärmeausdehnungskoeffizienten des Kühlelementes so einzustellen, daß dieser zumindest an der Montagefläche nicht oder allenfalls nur noch vernachlässigbar gering von dem Wärmeausdehnungskoeffizienten des Materials der Laserdiodenanordnung, beispielsweise von GaAs abweicht.

Ein weiterer wesentlicher Vorteil besteht darin, daß auch die Festigkeit bzw. Formbeständigkeit gegenüber mechanischen Belastungen durch den Anteil an Keramik wesentlich verbessert wird.

Bei einer bevorzugten Ausführungsform erstreckt sich der Teilbereich oder Einsatz aus Keramik und/oder Diamant und/oder T-cBN über die volle Breit der Montagefläche.

Bei dem erfindungsgemäßen Kühlelement sind die verwendeten Kupferschichten und Keramikschichten jeweils bevorzugt unter Verwendung der DCB-Technik flächig miteinander verbunden, und zwar ohne Verwendung zusätzlicher Hilfsstoffe, so daß der geringere Wärmeausdehnungskoeffizient der wenigstens einen Keramikschicht sich unmittelbar reduzierend auf den Wärmeausdehnungskoeffizienten des gesamten, mehrschichtigen Kühlelementes auswirken kann, d.h. die Kupferschichten unmittelbar und ohne eine nachgiebige Zwischenschicht in ihrer Wärmeausdehnung durch die wenigstens eine Keramikschicht gebremst werden.

Bei einer Ausführungsform der Erfindung besteht das Kühlelement aus mehreren stapelartig übereinander angeordneten und flächig miteinander verbundenen Schichten, von denen dann wenigstens eine Schicht eine Metallschicht, beispielsweise Kupferschicht bildet und zumindest eine Schicht zumindest in einem Teilbereich aus einem Material besteht, welches ein im Vergleich zu dem Metall geringeren Wärmeausdehnungskoeffizienten aufweist, wobei die Schichtfolge symmetrisch zu der parallel zu den Oberflächenseiten des Kühlelementes verlaufenden Mittelebene ausgebildet ist. Zur Bildung der Kühlstruktur bzw. Kühlebene des Kühlelementes ist dann wenigstens eine Schicht mit wenigstens einer Ausnehmung versehen, die zur Bildung wenigstens eines sich in der Ebene dieser Schicht erstreckenden Kanals einen den Kanal bildenden schlitzförmigen Abschnitt aufweist und durch angrenzende Schichten an der Ober- und Unterseite verschlossen ist. In den angrenzenden Schichten sind dann räumlich gegeneinander versetzt in den Kanal mündende Öffnungen zum Zu- und Abführen des den Kanal durchströmenden Kühlmediums vorgesehen.

In dem mehrlagigen Kühlelement können dann mehrere derartige Kühlebenen vorgesehen sein, die entweder mit ihren durch die Öffnungen gebildeten Ein- und Auslässen funktionsmäßig in Serie liegen oder aber parallel zueinander angeordnet sind.

Um auch eine möglichst wirksame Kühlwirkung bzw. Wärmesenke für die Laserdiodenanordnung zu erreichen, ist bei einer Ausführungsform der Erfindung beidseitig von einer Kühlebene jeweils eine Kupferzwischenschicht vorgesehen ist, die flächig mit der Kühlebene verbunden ist, die wiederum aus Kupfer besteht. Die Kupferzwischenschichten sind dann an ihren außenliegenden Seiten mit einer weiteren äußeren Kupferschicht versehen, und auf einer dieser äußeren Schichten befindet sich die Laserdiodenanordnung, wobei unterhalb der Laserdiodenanordnng in der Kupferzwischenschicht zur Reduzierung des Wärmeausdehnungskoeffizienten ein Einsatz oder eine vergrabene Schicht aus Diamant oder T-cBN eingebracht ist, der auch eine Verbesserung der Wärmeleitfähigkeit bringt, wobei die verbesserte Leitfähigkeit des eingelegten Materials bei dieser Ausführungsform zugleich als Wärmespreitzer verwendet wird.

Entsprechend einem zweiten Aspekt geht es um die Schaffung eines Diodenlasermoduls mit potentialfreien Kühlkörpern. Dieses Diodenlasermodul setzt sich aus einer Vielzahl von Diodenlaserbauelementen zusammen, die übereinander gestapelt zu dem Modul miteinander verbunden sind. Die einzelnen Diodenlaserbauelemente sind hinsichtlich ihrer von Metallisierungen gebildeten Kontakte oder Kontaktflächen so ausgebildet, daß durch das Stapeln sämtliche Diodenlaseranordnungen bzw. deren Laserdiodenanordnungen elektrisch in Serie zwischen zwei äußeren elektrischen Anschlüssen liegen, so daß für die Ansteuerung mit der notwendigen Leistung bei höherer Spannung (Summe der Einzelspannungen der Laserdiodenanordnungen) ein geringer, für sämtliche Laserdiodenanordnungen gemeinsamer Strom ausreichend ist. Um Interaktionen zwischen Strom, metallischem bzw. leitendem Kühlkörper und Kühlmedium zu vermeiden, sind die Kühlkörper der einzelnen Diodenlaserelemente potentialfrei im Stapel vorgesehen, d.h. diese Kühlelemente und dabei insbesondere auch der elektrisch leitende Teil dieser Kühlelemente sind gegenüber strom- oder spannungsführenden Teilen, insbesondere auch gegenüber Metallisierungen der Diodenlaserelemente jeweils elektrisch isoliert, so daß sich zwischen einem Kühlkörper und dem diesen Kühlkörper durchströmenden Kühlmedium eine Spannungsdifferenz nicht aufbauen kann.

Weiterbildungen der Erfindung sind Gegenstand der Unteransprüche.

Die Erfindung wird in Folgenden anhand der Figuren an Ausführungsbeispielen näher erläutert. Es zeigen:
- Figur 1: in perspektivischer Explosionsdarstellung ein unter Verwendung eines Kühlkörpers oder Substrates gemäß der Erfindung hergestelltes Diodenlaserbauelement;
- Figur 2: in ähnlicher Darstellung wie Figur 1 eine abgewandelte Ausführungsform;
- Figuren 3 - 7: in sehr vereinfachten Darstellungen weitere, bevorzugte Ausführungsformen des erfindungsgemäßen Diodenlaserbauelementes mit Kühlelement;
- Figur 8: in vereinfacher Explosionsdarstellung und in Seitenansicht ein Diodenlasermodul, welches von mehreren stapelartig übereinander angeordneten Diodenlaserbauelementen gebildet ist.

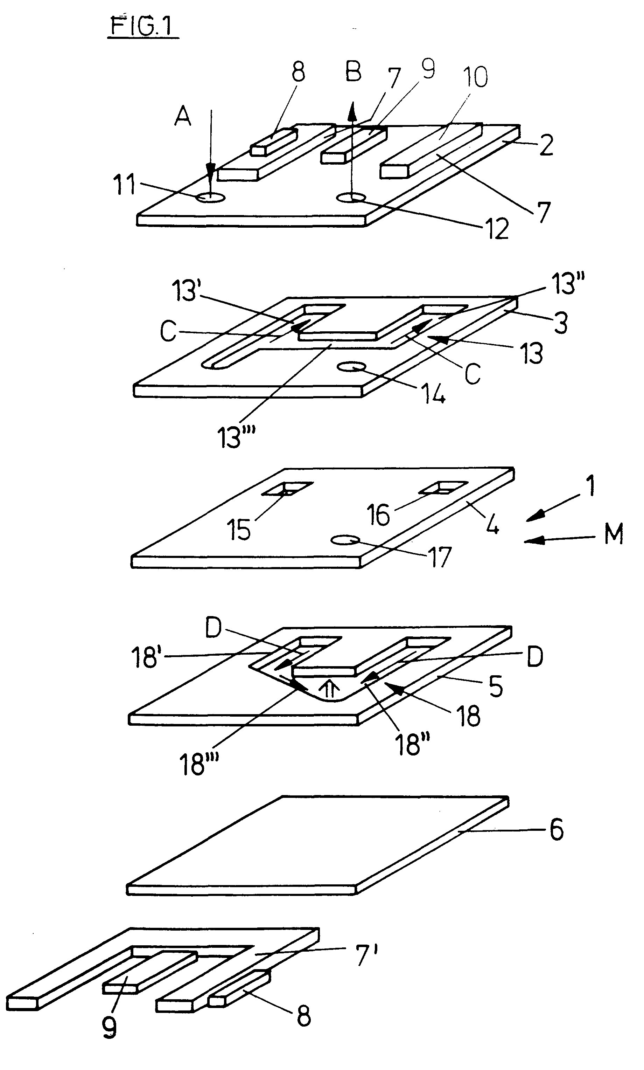

In der Figur 1 ist ein mehrlagiges, zugleich als Kühlkörper oder Kühlelement ausgebildetes Substrat wiedergegeben, welches insgesamt aus fünf Schichten oder Lagen besteht, nämlich aus der in der Figur 1 oberen Schicht 2 aus Keramik, beispielsweise aus einer Aluminium-Oxyd-Keramik (Al₂O₃) aus der von einer Kupferfolie gebildeten Kupferschicht 3, aus der ebenfalls aus einer Kupferfolie gebildeten Kupferschicht 4, aus der von einer Kupferfolie gebildeten Kupferschicht 5 sowie aus der Keramikschicht 6, die ebenfalls beispielsweise eine Aluminiumoxyd-Keramik ist.

Sämtliche Schichten 2 - 6 besitzen bei der dargestellten Ausführungsform einen quadratischen Zuschnitt. Es versteht sich, daß auch andere Zuschnitte für diese Schichten denkbar sind. Weiterhin besitzen sämtlicht Schichten 2 - 6 jeweils die gleiche Größe.

Auf der Oberseite der Keramikschicht 2 sind Leiterbahnen oder Kontaktflächen 7 vorgesehen. Weiterhin befinden sich auf der Oberseite der Keramikschicht 2 verschiedene elektronische Bauelemente 8 - 10 in Form von Chips. Diese sind in geeigneter Weise und unter Verwendung bekannter Techniken an der Oberseite der Keramikschicht 2 bzw. an den dortigen Leiterbahnen 7 und Kontaktflächen befestigt.

Außerhalb des von den Leiterbahnen 7 und den Bauelementen 8 - 10 eingenommenen Bereichs besitzt die Keramikschicht 2 zwei Öffnungen oder Durchlässe 11 bzw. 12, von denen der Durchmlaß 11 entsprechend dem Pfeil A zum Zuführen eines Kühlmediums und der Durchlaß 12 entsprechend den Pfeil B zum Abführen des Kühlmediums dienen. Das Zuführen und Abführen dieses Kühlmediums, welches im einfachsten Fall Wasser ist, aber auch ein anderes flüssiges oder gasförmiges Medium sein kann, erfolgt über nicht dargestellte Kanäle, die dicht an die Durchlässe 11 und 12 angeschlossen sind.

In der Kupferschicht 3 ist eine zum Umfang dieser Schicht hin geschlossene erste Öffnung 13 vorgesehen, die im wesentlichen aus zwei parallelen Abschnitten 13' und 13" besteht, die über einen Abschnitt 13''' miteinander verbunden sind. Weiterhin besitzt die Kupferschicht 3 eine von der Öffnung 13 getrennte Öffnung 14.

Die Kupferschicht 4 besitzt insgesamt drei räumlich gegeneinander versetzte und voneinander getrennte fensterartige Öffnung 15, 16 und 17. In der Kupferschicht 5 ist schließlich eine Ausnehmung oder Öffnung 18 vorgesehen, die entsprechend der Öffnung 13 zwei im wesentlichen parallele Abschnitte 18' und 18" sowie einen diesen miteinander verbindenen Abschnitt 18''' aufweist.

Die Durchlaßöffnungen 11 und 12 sowie die Öffnungen 13 - 18 sind derart in den einzelnen Schichten angeordnet und orientiert, daß bei miteinander verbundenen Schichten 2 - 6 die Öffnungen 13 und 18 mit ihren Abschnitten 13' - 13" bzw. 18' - 18''' jeweils in der Ebene dieser Schichten verlaufende Verteilerkanäle zwischen der Keramikschicht 2 und der Kupferschicht 4 bzw. zwischen der Kupferschicht 4 und der Keramikschicht 6 bilden, daß die Abschnitte 13' und 18' im wesentlichen deckungsgleich untereinander parallel zueinander verlaufen sowie auch die Abschnitte 13" und 18", daß die Durchlaßöffnung 11 in den Abschnitt 13' im Bereich des einen Endes dieses Abschnittes mündet, daß das andere Ende des Abschnittes 13' über die fensterartige Öffnung 15 mit dem Abschnitt 18''' entfernt liegenden Ende des Abschnittes 18' in Verbindung steht, daß das dem Abschnitt 13''' entfernt liegende Ende des Abschnittes 13" über die fensterartige Öffnung 16 mit dem Abschnitt 13''' entferntliegenden Ende des Abschnittes 18" in Verbindung steht, und daß die jeweils den gleichen Querschnitt aufweisenden Öffnungen 12, 14 und 17 deckungsgleich miteinander angeordnet sind und einen durch die Schichten 2 - 4 reichenden Kanal zum Rückführen des Kühlmediums bilden, der von den Abschnitt 18"' ausgeht. Die fensterartigen Öffnungen 15 und 16 besitzen bei der dargestellten Ausführungsform einen Querschnitt der so gewählt ist, daß sich für das Kühlmedium in den Abschnitten 13' und 13" bzw. 18' und 18" eine gleichmäßige Verteilung ergeben.

Durch die vorbeschriebene Ausbildung wird das über die Durchlaßöffnung 11 zugeführte Kühlmedium in der von der Öffnung 13 gebildeten Kanalanordnung verteilt, und zwar auf die beiden Abschnitte 13' und 13'' und strömt in diesen Abschnitten bei der für die Figur 1 gewählten Darstellung von vorne nach hinten (Pfeile C). Nach dem Durchtritt durch die Öffnungen 15 strömt das Kühlmedium dann in den Abschnitten 18' und 18" in umgekehrter Richtung, d.h. bei der für die Figur 1 gewählten Darstellung von hinten nach vorne (Pfeile D), so daß sich ein Gegenstromprinzip und damit eine möglichst gleichmäßige Kühlung des Substrates 1 ergibt.

Für die Kühlwirkung wesentlich ist auch, daß das Kühlmedium beim Durchströmen des Substrates bzw. der in diesem Substrat durch die Öffnungen 13 und 18 gebildeten Kühlkanäle mehrfach umgelenkt wird; und zwar jeweils aus einer Richtung senkrecht zur Ebene des Substrates in eine in dieser Ebene liegende Strömungsrichtung und umgekehrt. Hierbei werden insbesondere auch die Kupferschicht 4 sowie die Keramikschicht 6 intensiv von dem Kühlmedium angeströmt.

Auf der Unterseite der Keramikschicht 6 sind wiederum Leiterbahnen oder Kontaktflächen 7' sowie Bauelemente 8 - 10 in Form von Chips vorgesehen.

Wesentlich bei dem beschriebenen Substrat ist auch, daß dieses hinsichtlich der für die Schichten verwendeten Materialien symmetrisch zu einer parallel zur Ober- und Unterseite des Substrates 1 verlaufenden Mittelebene ausgebildet ist, die bei der dargestellten Ausführungsform die Mittelebene der Kupferschicht 4 ist. Durch diese symmetrische Ausbildung ist gewährleistet, daß Temperaturänderungen des Substrates nicht zu einer bimetallartigen Verformung führen können. Durch die Verwendung der Keramikschichten 2 und 6 ist gewährleistet, daß das Substrat gegenüber einen Substrat oder Kühlkörper welches bzw. welcher ausschließlich aus Metall oder Kupfer besteht, nur einen stark reduzierten Wärmeausdehnungskoeffizienten aufweist. Während die Kupferschichten 3 - 5 einen Wärmeausdehnungskoeffizienten größer als 15 10⁻⁶ K⁻¹ aufweist, liegt der Wärmeausdehnungskoeffizient der Keramikschichten 2 und 6 deutlich unter 10 · 10⁻⁶ K⁻¹, so daß sich für das Substrat 1 bzw. für das dieses Substrat bildende Verbundmaterial ein gegenüber Kupfer stark reduzierter Wärmeausdehnungskoeffizient erreicht wird. Gleichzeitig weist das Substrat aber eine hohe Wärmeleitfähigkeit auf, was nicht nur für die Kupferschichten 3 - 5, sondern auch für die Keramikschichten 2 und 6 gilt, so daß auch insoweit eine hohe Kühlwirkung erreicht wird.

Es versteht sich, daß die Schichten 2 - 6 flächig miteinander zu dem Substrat 1 verbunden sind. Hierfür eigenen sich die unterschiedlichsten Techniken, beispielsweise DCB-Verfahren oder Aktiv-Lot-Verfahren.

Die vorbeschriebene Ausbildung des Substrates 1 bzw. die dortige Gestaltung der von dem Kühlmedium durchströmten Kanäla hat speziell bei durch Löten miteinander verbundenen Schichten 2 - 6 auch den Vorteil, daß die Angriffsflächen innerhalb der Kanäle, an denen das Kühlmedium auf das verwendete Lot einwirken könnte, äußerst klein sind.

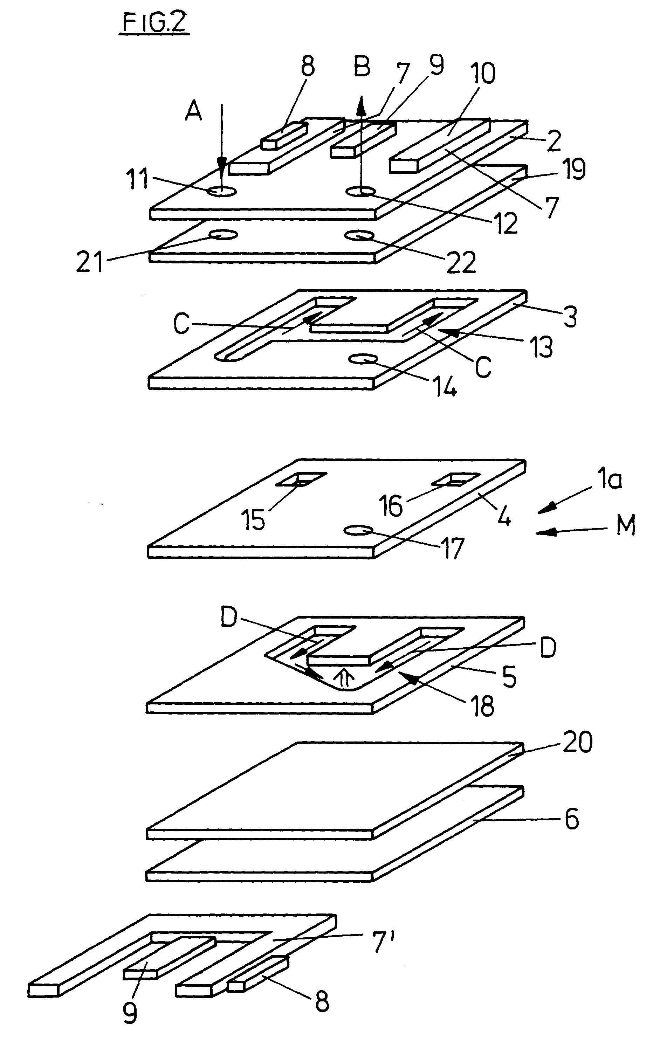

Die Figur 2 zeigt ein Substrat 1a, welches sich von dem Substrat 1 im wesentlichen nur dadurch unterscheidet, daß zwischen der Schicht 2 und der Schicht 3 sowie ebenso zwischen der Schicht 5 und der Schicht 6 jeweils eine weitere Schicht 19 bzw. 20 vorgesehen ist, die bei der dargestellten Ausführungsform jeweils eine von einem Zuschnitt einer Kupferfolie gebildete Kupferschicht ist und für eine noch gleichmäßigere Abführung der Wärme von den Keramikschichten 2 bzw. 6 sorgt. Für den Durchtritt des Kühlmediums ist die Schicht 19 mit zwei Öffnungen 21 und 22 versehen, von denen die Öffnung 20 deckungsgleich mit der Öffnung 11 und die Öffnung 22 deckungsgleich mit der Öffnung 12 angeordnet ist.

Die Herstellung des Substrates 1 ist beispielsweise in folgender Weise möglich:
1. Keramik aus Aluminiumoxyd durch Ritzen und Brechen auf das Maß der Schicht 2 bringen und anschließend Öffnungen 11 und 12 durch Schneider oder auf andere Weise einbringen;
2. Kupferfolie für die Leiterbahn und Kontaktflächen 7 auf Maß schneiden;
3. Kupferfolie für die Leiterbahn 7 mit einer Oxydschicht versehen, und zwar durch Wärmebehandlung über drei Minuten bei 400°C;
4. Kupferschicht für Leiterbahn 7 mittels DCB-Verfahren auf Keramikschicht 2 befestigen, d.h. hierfür Kupferfolie für Leiterbahn 7 auf Keramikschicht 2 aufliegen und 2,5 Minuten bei 1070°C in Schutzgas mit weniger als 40ppO₂ behandeln.
5. Ätzen der Kupferschicht ist im Verfahrensschritt 4 hergestellten Verbundes zur Erzeugung der Leiterbahn 7 sowie der Kontaktflächen;
6. Zuschneiden und Ätzen der Kupferschicht 3;
7. Zuschneiden und Ätzen der Kupferschicht 4;
8. Zuschneiden und Ätzen der Kupferschicht 5;
9. Aluminiumoxyd-Keramik durch Ritzen und Brechen auf das erforderliche Maß für die Keramikschicht 6 brigen;
10.Kupferfolie für die Leiterbahn 7' und die weiteren Kontaktflächen auf Maß zuschneiden;
11.Zugeschnittene Kupferfolie mit einer Oxydschicht durch Wärembehandlung über 3 Minuten bei 400°C versehen.
12.Kupferfolie mit Keramikschicht 6 durch DCB-Verfahren verbinden, und zwar durch Auflegen der Kupferfolie auf die Keramikschicht 6 und durch Behandeln über eine Dauer von 2,5 Minuten bei 1070°C in Schutzgasatmosphäre mit weniger als 40ppmO₂;
13.Herstellung der Leiterbahn 7 sowie weiterer Kontakflächen aus der Kupferschicht durch Ätzen;
14.Kupferschichten 3 - 5 durch Wärmebehandlung (bei 400°C und über Dauer von 3 Minuten) mit Oxydschicht versehen;
15.Aufeinanderliegen der Schichten 2 - 6 und Verbinden mittels des DCB-Prozesses, d.h. durch Behandlung über eine Zeitdauer von 2,5 Minuten bei 1077°C in Schutzgas mit weniger als 40ppmO₂.

Die Herstellung des Substrates 1a erfolgt in gleicher Weise, lediglich mit der zustäzlichen Maßnahme, daß auch die Schichten 19 und 20 durch Zuschneiden sowie die Schicht 19 bzw. deren Öffnungen 21 und 22 durch Ätzen hergestellt werden.

Die Dicke der einzelnen Schichten ist beispielsweise wie folgt gewählt:
Schicht 2 0,25 - 1 mm
Schicht 3 0,3 - 3 mm
Schicht 4 0,1 - 0,5 mm
Schicht 5 0,3 - 3,0 mm
Schicht 6 0,25 - 1,0 mm.

Die Dicke der zusätzlichen Schichten 19 und 20 beträgt beispielsweise 0,1 - 0,5 mm.

Die Ausnehmungen bzw. Öffnungen 11 - 18 sind jeweils durchgehend ausgeführt, d.h. sie reichen von der Oberseite bis an die Unterseite der jeweiligen Schicht.

Bei dem vorstehend beschriebenen Ausführungsbespiel ist mit 10 jeweils eine Hochleistungslaserdiode oder ein Hochleistungslaserdiodenchip mit einem oder aber bevorzugt mit mehreren Emittern zur Abgabe eines oder mehrer Laserstrahlen bezeichnet. 8 und 9 sind dann zusätzliche Bauelemente oder Chips, die beispielsweise zur Ansteuerung des Laser-Chip dienen, aber nicht unbedingt vorhanden sein müssen.

Bei den in den Figuren 1 und 2 wiedergegebenen Ausführungsformen weist das als Kühlelement dienende Mehrfach-Substrat 1 bzw. 1a zwei Kühlebenen auf, die im wesentlichen von den Kupferschichten 3 und 5 in Verbindung mit den jeweils angrenzenden Schichten gebildet sind.

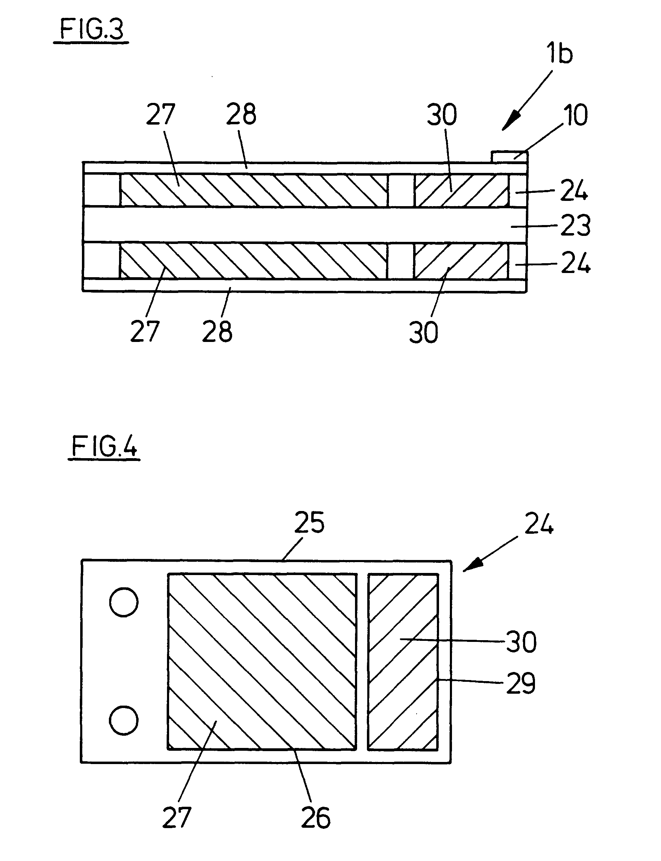

Die Figuren 3 - 5 zeigen weitere, bevorzugte Ausführungsformen der Erfindung, wobei bei den Ausführungen der Fig. 3 - 6 das zugleich als Kühlelement ausgebildete Substrat ebenfalls symmetrisch zu einer Mittelebene M ausgeführt ist.
Bei der in der Fig. 3 wiedergegebenen Ausführungsform umfaßt das Substrat 1b eine Kühlebene 23, an der jeweils beidseitig eine Schicht 24 vorgesehen und mit der Kühlebene flächig verbunden ist. Wie in der Fig. 4 dargestellt ist, besteht jede Schicht 24 aus einer Folie oder Platte 25 aus Kupfer, die Öffnungen 26 und 29 aufweist. In die Öffnung 26 ist ein plattenförmiger Einsatz 27 aus Keramik eingesetzt, dessen Dicke gleich der Dicke der Platte ist. In die Öffnung 29 ist ein streifen- oder rechteckförmiger Einsatz 30 aus einem Material mit hoher Wärmeleitfähigkeit, nämlich aus Diamant oder T-cbN eingesetzt. Auf der der Kühlebene 23 abgewandten Seite ist eine Kupferschicht 28 auf jeder Schicht 24 flächig befestigt. Die obere Kupferschicht 28 bildet oberhalb des Einsatzes 30 die Montagefläche, an der der Hochleistungslaser-Chip 10 befestigt ist, d.h. dieser befindet sich oberhalb des Einsatzes 30 der oberen Schicht 24. Die aktive Schicht der Hochleistungslaserdiodenanordnung 10 bzw. der Laser-Licht emittierenden Emitter liegt in einer Ebene parallel zu den Oberflächenseiten der Kupferschicht 28, und zwar mit der sogenannten "slow axis" in einer Achsrichtung senkrecht zur Zeichenebene der Fig. 3 und mit der sogenannten "fast axis" senkrecht zu der Ebene der Kupferschicht 28. Der Einsatz 30 ist dabei so gewählt, daß dessen Länge senkrecht zur Zeichenebene der Fig. 3 größer ist als die Breite, die die Hochleistungslaserdiodenanordnung 10 in dieser Achsrichtung besitzt.

Hergestellt ist das Substrat 1b beispielsweise dadurch, daß in einem ersten Arbeitsgang mit Hilfe des DCB-Verfahrens die die Kühlebene bildenden Kupferschichten und auch die Schichten 24 mit dem Einsatz 27 aus Keramik miteinander verbunden werden. In einem zweiten Arbeitsgang erfolgt dann mit Hilfe eines Aktiv-Lot-Verfahrens das Einlöten der vorzugsweise mit einer Metallisierung versehenen Einsätze 30 in die beiden Schichten 24 bzw. die dortigen Ausnehmungen29, wobei in einem dritten Verfahrensschritt oder aber bereits in dem zweiten Verfahren ebenfalls mit Hilfe des Aktiv-Lotes die beiden äußeren Kupferschichten 28 auf die außenliegenden Oberflächenseiten der Schicht 24 aufgebracht werden. Die Einsätze 30 unterhalb der Hochleistungslaserdiodenanordnung 10 tragen entscheidend zur Reduzierung des Wärmeausdehnungskoeffizienten des Substrates 1b insbesondere im Bereich der Montagefläche bei, bewirken aber auch eine verbesserte Wärmeableitung der Verlustwärme von der Hochleistungsdiodenlaseranordnung 10 an die Kühlebene 23. Zugleich wird die hohe Wärmeleitfähigkeit des Einsatzes auch als Wärmespreitzer verwendet.

Die Einsätze 27 und 30 bilden somit vergrabene Bereiche, die den Wärmeausdehnungskoeffizienten des Substrates 1b an den Wärmeausdehnungskoeffizienten des Chip-Materials (GaAs) der Diodenlaseranordnung 10 anpassen.

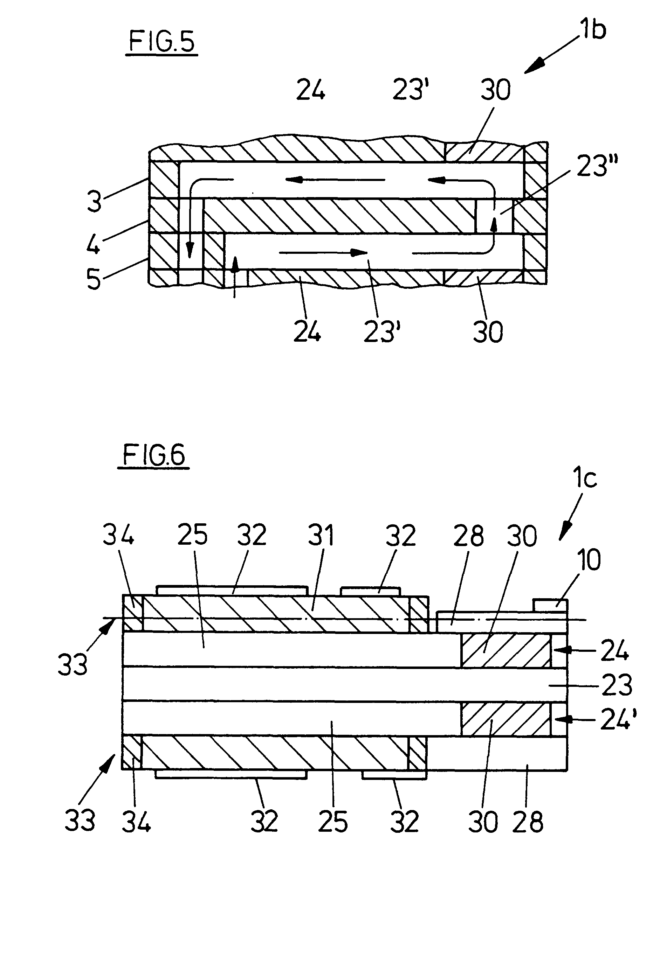

Fig. 5 zeigt nochmals in etwas vergrößerter Darstellung und mehr im Detail eine mögliche Ausbildung der Kühlebene 23. Diese Kühlebene 23 besteht bei der dargestellten Ausführungsform aus den drei Kupferschichten 3, 4 und 5, die flächig miteiander verbunden sind, wobei die Kupferschichten 3 und 5 die von den Ausnehmungen 13 und 18 gebildeten Kanäle 23' aufweisen und in der Kupferschicht 4 wenigstens eine von den Öffnungen 15 und 16 gebildeter Durchlaß 23" vorgesehen ist. Das Kühlmedium (z.B. Kühlwasser) durchströmt die Schichten 3 - 5 bzw. die dort gebildeten Kanäle 23' und Öffnungen 23" in einer zu den Figuren 1 und 2 umgekehrten Strömungsrichtung. Der wenigstens eine Durchlaß 23" befindet sich in der Kühlebene 23 unterhalb des Einsatzes 30 bzw. unterhalb der Montagefläche für die Hochleistungslaserdiodenanordnung 10, so daß durch den Aufprall des Kühlmediums nach dem Durchtritt durch den Durchlaß 23" auf die Unterseite des Einsatzes 30 eine verbesserte Wärmeübertragung der Verlustwärme an das Kühlmedium (Kühlwasser) erreicht wird. Eine Besonderheit dieser Ausführung besteht somit auch darin, daß der eine Einsatz 30 unterhalb der Montagefläche direkt von dem Kühlmedium angeströmt wird.

Es versteht sich, daß die Kühlebene 23 auch anders ausgebildet sein kann, wobei die von den durchgehenden Ausnehmungen 13 und 18 in den Schichten 3 und 5 hergestellten Kanälen 23' den Vorteil haben, daß diese Kanäle besonders einfach realisiert werden können.

Fig. 6 zeigt als weitere Ausführungsform ein Substrat 1c, welches sich von dem Substrat 1b im wesentlichen zunächst dadurch unterscheidet, daß sich die äußeren Kupferschichten 28, von denen die obere Kupferschicht 28 wiederum die Montagefläche für die Hochleistungslaserdiodenanordnugn 10 bildet, nur über einen Teilbereich der Ober- und Unterseite des Substrates 1c erstrecken, und zwar oberhalb der Einsätze 30, und daß anstelle der Schichten 24 Schichten 24' verwendet sind. Letztere unterscheiden sich von den Schichten 24 dadurch, daß die Metallplatte 25 die Ausnehmung 26 nicht besitzt und auch der Keramikeinsatz 27 nicht vorhanden ist. Auf die der Kühlebene 23 abgewandten Oberflächenseiten der Schichten 24' eine äußere Keramikschicht 31 aufgebracht ist, auf der eine weitere Metallisierung bzw. Metallschicht 32 für Leiterbahnen aufgebracht ist.

Bei dem in der Fig. 6 wiedergegebenen Substrat sind die äußeren Keramikschichten 31 Bestandteil einer Teilschicht 33, die ähnlich den Schichten 24 aus einer Folie oder Platte 34 aus Kupfer bestehen. Die äußeren Keramikschichten 31 sind dann als Einsätze in Ausnehmungen dieser Platte 34 eingesetzt. Die Kupferschicht 28 deckt den jeweiligen Einsatz 30 vollständig ab, d.h. überlappt die jeweilige Ausnehmung 29 für diesen Einsatz. Über die Platte 34 können auch elektrische oder thermische Verbindungen bzw. Brücken von der äußeren Kupferschicht 32 an die Schicht 24 bzw. den dortigen Kupferbereich hergestellt werden.

Die Funktion des Keramikeinsatzes 27 übernehmen bei dem Substrat 1c die beiden äußeren Keramikschichten 31. Grundsätzlich ist es auch möglich, die Schichten 28 jeweils als Bestandteil der Platte 34 bzw. der Schicht 33 auszubilden.

Die Herstellung des Substrates 1c erfolgt bevorzugt derart, daß in einem Arbeitsgang mit Hilfe des DCB-Verfahrens die die Kühlebene 23 bildenden Schichten, die Schichten 24' ohne die Einsätze 30, die Schichten 33 mit den äußeren Keramikschichten 31 und die die Leiterbahnen bildenden äußeren Kupferschichten 32 mittels des DCB-Prozesses miteinander verbunden werden. In einem zweiten Verfahrensschritt werden dann die vorzugsweise metallisierten Einsätze 30 mit Aktiv-Lot in die Ausnehmungen 29 eingelötet und dann in dem gleichen Verfahrensschritt oder in einem anschließenden Verfahrensschritt die äußeren Kupferschichten 28 ebenfalls mit Aktiv-Lot befestigt.

Auch bei dieser Ausführungsform ist das Mehrfach-Substrat symmetrisch zu der Mittelebene M ausgebildet und insbesondere die Einsätze 30 dienen dazu, den Wärmeausdehnungskoeffizienten des Mehrfach-Substrates an der Montagefläche an den Wärmeausdehnungskoeffizienten des Chip-Materials anzupassen.

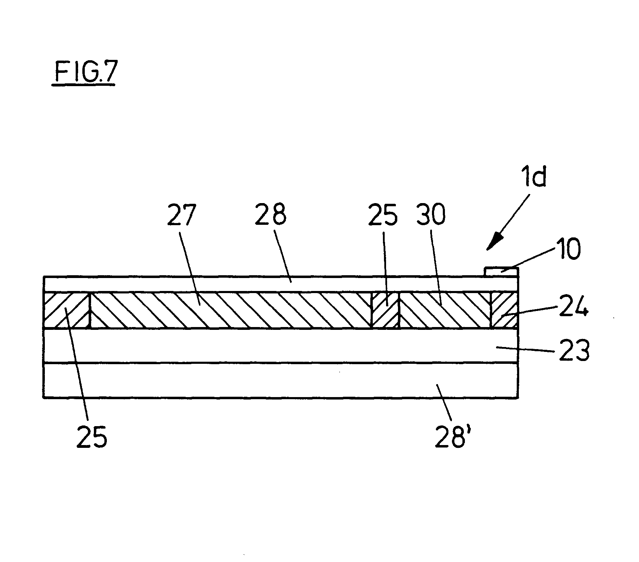

Fig. 7 zeigt schließlich als weitere sehr vereinfachte Ausführungsform ein Substrat 1d, welches den Vorteil des symmerischen Aufbaus nicht aufweist und sich von dem Substrat 1b der Figuren 3 - 5 dadurch unterscheidet, daß zwar an der Oberseite der Kühlebene 23 die Schichten 24 und 28 vorgesehen ist, an der Unterseite des Substrates aber eine Metall- oder Kupferschicht 28' vorgesehen ist, die einen Vergleich zur Kupferschicht 28 größerer Dicke besitzt. Auch dieses Substrat 1d wird wiederum so hergestellt, daß in einem ersten gemeinsamen Arbeitsgang mit Hilfe des DCB-Verfahrens die die Kühlebene 23 bildenden Schichten, die Schicht 24 (mit dem Einsatz 27, aber ohne den Einsatz 30) und die Schicht 28' flächig miteinander verbunden werden. Im Anschluß daran erfolgt das Einsetzen und Befestigen des Einsatzes 30 durch Aktiv-Lot sowie das Befestigen der oberen Kupferschicht 28, ebenfalls mit Aktiv-Lot.

Weiterhin ist es bei bei den in den Figuren 3 - 7 dargestellten Ausführungsformen auch möglich, daß die Schicht 24 bzw. 24' oder die diese Schicht bildende Platte ihrerseits aus mehreren, mittels des DCB-Verfahrens miteinander verbundenen Einzel-Schichten besteht.

Weiterhin besteht auch die Möglichkeit, anstelle der Kupferschicht 28 Kupfer beispielsweise galvanisch auf der Schicht 24' und/oder 24 abzuscheiden, und zwar auf der oberen Schicht 24' selbstverständlich nach dem Einsetzen des Einsatzes 30.

Die vergrabene Bauweise, d.h. die Verwendung der Kupferschicht hat den Vorteil, daß hierdurch die Möglichkeit einer mechanischen Nachbehandlung der Oberflächen durch spanende Verfahren besteht. Weiterhin besitzt das Substrat 1c bzw. 1d dann auch optimale elektrische Eigenschaften, da die Kupferschicht 28 eine relativ große Dicke (größer als 100 µm) aufweist und damit einen ausreichend großen elektrischen Querschnitt für den Anschluß bzw. Betrieb der Hochleistungslaserdiodenanordnung 10 gewährleistet.

Alle beschriebenen Ausführungsformen haben den generellen Vorteil, daß die von dem Kühlmedium durchströmten Kanäle große Abmessungen aufweisen, diese Kanäle also als Makro-Kanäle einfach herstellbar sind. Da das Kühlmedium durch die Umlenkung seines Flusses direkt unterhalb des jeweiligen Bauelementes senkrecht auf eine dortige Fläche trifft, wird dort durch turbulente Strömung eine optimale Kühlwirkung erreicht. Durch die mehrschichtige Ausbildung des jeweiligen Kühlelementes bzw. Substrates unter Verwendung von Keramikschichten wird der Ausdehnungskoeffizient der Montagefläche an das für die Bauelemente verwendete Chip-Material angepaßt. Durch die relativ großen Querschnitte der Kanäle ist es weiterhin auch möglich, die Druckdifferenz des Druckens des Kühlmediums zwischen Zulauf und Ablauf innerhalb des Kühlelementes klein zu halten, beispielsweise unter 1 bar. Hierdurch kann auch ein Kühlsystem realisiert werden, daß unterhalb des Umgebungsdruckes betrieben wird und in welchem daher ein Austreten von Kühlmedium wirksam verhindert ist.

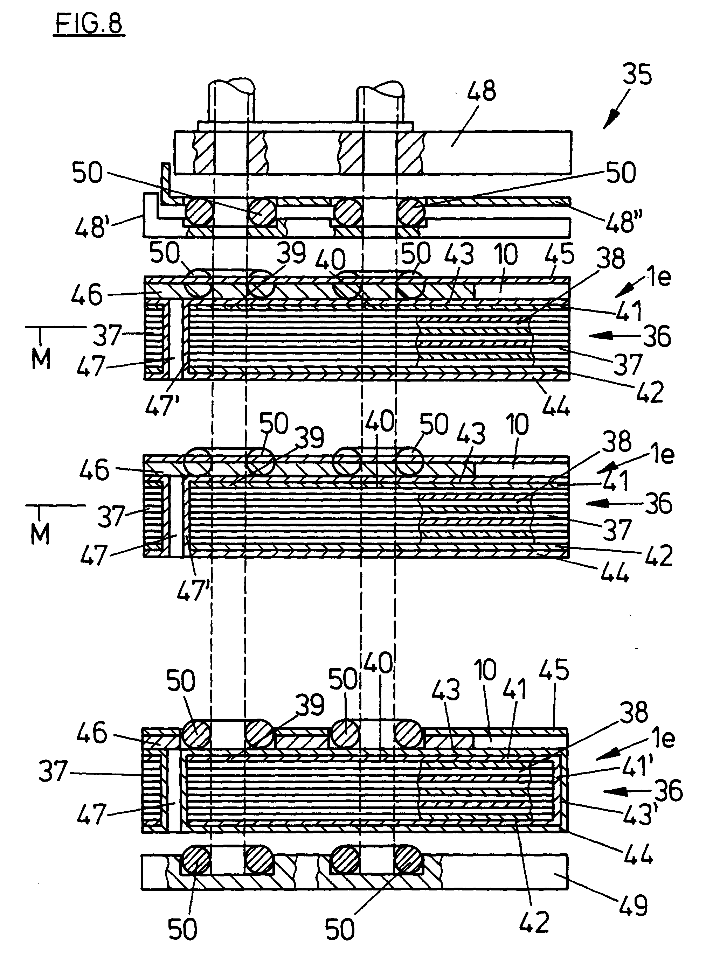

Die Fig. 8 zeigt in vereinfachter Darstellung und in Seitenansicht ein Diodenlasermodul 35, welches aus einer Vielzahl von stapelartig übereinander angeordneten Diodenlaserelementen 1e besteht, die zur übersichtlicheren Darstellung in der Fig. 8 voneinander getrennt gezeichnet sind, im Modul 35 aber tatsächlich dicht aneinander anschließen, und zwar derart, daß jedes Element 1e mit seiner Unter- und/oder Oberseite an jeweils ein benachbartes Element dicht anschließt. Jedes Element 1e besteht aus der Wärmesenke bzw. im Kühlkörper 36, der seinerseits aus einer Vielzahl von paketartig übereinander angeordneten und flächig miteinander verbundenen Kupferschichten 37 besteht, wobei die Verbindung der die Kupferschichten 37 bildenden dünnen Bleche wiederum durch die DCB-Technik erfolgt. Die Schichten 37 sind so strukturiert, daß im Kühlkörper 36 von einem flüssigen Kühlmedium durchströmte Kühlkanäle 38 gebildet sind. Die Kühlkanäle 38 stehen jeweils mit Kanälen 39 und 40 in Verbindung, die mit ihren Achsen senkrecht zur Ober- und Unterseite des jeweiligen Diodenlaserelementes 1e liegen und von der Oberseite an die Unterseite dieses Elementes reichend durchgehend ausgebildet sind, und zwar derart, daß in dem Modul diese Kanäle 39 und 40 von der Oberseite des Moduls an die Unterseite dieses Moduls reichende Sammelkanäle zum Zuführen bzw. zum Abführen des Kühlmediums in die bwz. aus den Kanälen 38 bilden. Bei der dargestellten Ausführungsform bilden die Kanäle 39 beispielsweise den Vorlauf und die Kanäle 40 beispielsweise den Rücklauf für das Kühlmedium.

Der Kühlkörper 36 ist an seiner Oberseite mit einer Schicht 41 aus isolierendem Material und an der Unterseite mit einer Schicht 42, ebenfalls aus isolierendem Material versehen. Auf die den Schichten 37 abgewandte Seite der Schicht 41 ist eine Metallisierung 43. Auf die den Schichten 37 abgewandte Seite der Schicht 42 ist eine Metallisierung 44 aufgebracht. Die Schicht 43 bildet einen elektrischen Anschluß für die auf dieser Metallisierung befestigte Laserdiodenanordnung 10. An der Oberseite der Laserdiodenanordnung 10 ist eine weitere Metallisierung 45 vorgesehen, die als zweiter elektrischer Anschluß dient. Die beiden Metallisierungen 43 und 45 sind durch eine Isolierschicht 46 (Kapton-Folie) voneinander isoliert.

Durch eine Durchkontaktierung 47 sind die beiden Metallisierungen 43 und 44 elektrisch miteinander verbunden. Die Durchkontaktierung 47 ist (z.B durch eine Isolierhülse 47') gegenüber dem Kühlkörper 36 bzw. den Schichten 37 aus elektrisch leitendem Material isoliert. Die elektrische Verbindung zwischen den beiden Metallisierungen 43 und 44 kann auch dadurch hergestellt sein, daß diese Metallisierungen über einen durch die Isolierschicht 41' elektrisch isolierten Randbereich 43' miteinander verbunden sind.

Durch das Übereinanderstapeln der Diodenlaserelemente 1e liegt mit Ausnahme des obersten Elementes 1e jedes Element mit seiner oberen Metallisierung 45 jeweils gegen die untere Metallisierung 44 des darüberliegenden Elementes 1e an, so daß auf diese Weise eine elektrische Verbindung zwischen den im Stapel aufeinanderfolgenden Elementen 1e hergestellt ist. Die obere Metallisierung 45 des oberen Elementes 1e liegt gegen ein aus elektrisch leitendem Material hergestelltes Anschlußelement 48' an, welches als elektrischer Anschluß dient. Als Anschluß für das Zu- und Abführen des Kühlmediums dient ein Anschlußelement 48, welches gegenüber dem Anschlußelement 48' durch ein Isolierelement 48" elektrisch isoliert ist. Gegen die untere Metallisierung 44 des untersten Elementes 1c liegt ein unteres, ebenfalls aus elektrisch leitendem Material hergestelltes Anschlußelement 49 an, welches einen elektrischen Anschluß bildet und die von den achsgleich angeordneten Sammelkanälen 39 und 40 gebildeten Vor- und Rückläufe für das Kühlmedium an der Unterseite des Moduls verschließt. Durch Schrauben oder andere Verspannelemente, die ebenfalls elektrisch isoliert durch die einzelnen Diodenlaserelemente 1e und deren elektrisch leitende Schichten, durch das Anschlußelement 48' sowie auch durch das Anschlußelement 48 und/oder 49 hindurchgeführt sind, sind die einzelnen Elemente 1e in dem Stapel zu dem Modul 35 miteinander verbunden.

Durch den Anschluß über die Anschlußelemente 48 und 49 sind sämtliche Diodenlaseranordnungen 10 des Moduls elektrisch in Serie geschaltet, so daß das Modul bei geringem Strom und entsprechend hoher Spannung mit der erforderlichen elektrischen Leistung betrieben werden kann.

Eine Besonderheit des Moduls 35 besteht darin, daß die Kühlkörper 36 bzw. deren leitfähige Schichten 37 jeweils potentialfrei vorgesehen sind, d.h. der elektrisch leitende Teil jedes Kühlkörpers 36 über keine elektrische Brücke (Ohm'sche Verbindung) mit einer als Stromleiter dienenden Metallisierung verbunden ist.

Dies hat den Vorteil, daß beim Durchströmen der einzelnen Kühlkörper 36 mit dem flüssigen Kühlmedium während des Betriebes des Moduls in den Kühlkanälen 38, aber auch in den Kanälen 39 und 40 an keiner Stelle zwischen diesem Kühlmedium und dem elektrisch leitenden Material eine Spannungsdifferenz oder ein Potentialunterschied besteht und somit insbesondere auch Interaktionen zwischen dem elektrisch leitendem Material der metallischen Kühlkörper, dem Strom und dem Kühlmedium vermieden sind. Ist das Kühlmedium elektrisch leitend und bildet sich dementsprechend im Kühlmedium ein elektrisches Spannungsfeld zwischen dem oberen und unteren Anschluß 48 bzw. 49 aus, so können sich die elektrisch leitenden Teile bzw. Schichten 37 jedes Kühlkörpers 36 jeweils auf das Potential einstellen, welches das Kühlmedium jeweils an diesem Teil eines Kühlkörpers 36 aufweist.

Die Isolierschichten 41 und 42 sind beispielsweise Keramikschichten, z.B. solche aus Aluminiumoxid- oder Aluminiumnitrid-Keramik, wobei dann die Verbindung dieser Schichten mit dem elektrisch leitenden Teil des jeweiligen Kühlkörpers 36 (Schichten 37) und/oder mit den von Kupferschichten gebildeten Metallisierungen 43 und 44 wiederum durch DCB-Technik erfolgen kann. Die Metallisierungen 43 und 44 besitzen beispielsweise eine Schichtdicke von 100 bis 200 µ. Die Metallisierung 45 ist von einer Kupferfolie gebildet, die mit dem Laserdiodenelement bzw. mit einem dortigen Kontakt durch Löten verbunden ist. Zur Verbesserung der Wärmeableitung kann aber die Schicht 41 zumindest unterhalb der Laserdiodenanordnung 10 auch aus einem anderen Material bestehen, beispielsweise aus Diamant- und/oder TCBN.

Auch bei dieser Ausführungsform ist der Kühlkörper 36 durch die Schicht 41 sowie durch eventuelle weitere Schichten aus Keramik und/oder Diamant und/oder TCBN so ausgeführt, daß er wenigstens im Bereich der Laserdiodenanordnung 10 einen Wärmeausdehnungskoeffizienten aufweist, der zumindest in etwa im Bereich des Chip-Materials liegt, so daß thermische Spannungen im Chip vermieden werden.

Um einen Verzug oder eine Verformung des jeweiligen Kühlkörpers 36 durch thermische Einflüsse zu vermeiden, ist jeder Kühlkörper 36 hinsichtlich der Anzahl und Art der Schichten möglichst symmetrisch zu einer Mittelebene M aufgebaut. Mit 50 sind elastische Ringdichtungen (O-Ringe) bezeichnet, die bei im Stapel flächig gegeneinander anliegenden den Diodenlaserbauelementen 1e die Kanäle 39 und 40 an den Übergängen zwischen diesen Diodenlaserbauelementen 1e bzw. an den Übergängen zu den Abschlüssen 48 und 49 nach außen abdichten.

Die Erfindung wurde voranstehend an Asführungsbeispielen beschrieben. Es versteht sich, daß zahlreiche Änderungen sowie Abwandlungen möglich sind, ohne daß dadurch der der Erfindung zugrundeliegende Erfindungsgedanke verlassen wird.

So ist es beispielsweise möglich, weitere Schichten aus Keramik herzustellen, beispielsweise die Schicht 4, wobei zweckmäßigerweise aber diejenigen Schichten, die parallel zur Ebene des Substrates verlaufenden Kanalabschnitte für das Kühlmedium bilden, d.h. im vorliegenden Fall die Schichten 3 und 5 aus Kupfer oder einem anderen, geeigneten Metall hergstellt sind.

Als isolierendes Material oder Schichten können auch Gläser oder amorphe isolierende Schichten z.B. aus Keramik, insbes. auch aus Aluminium-Nitrid-Keramik verwendet werden.

### Bezugszeichenliste

- 1, 1c, 1d, 1e: Substrat
- 2: Keramikschicht
- 3 - 5: Kupferschicht
- 6: Keramikschicht
- 7, 7: Leiterbahn
- 8 - 10: elektrische Bauelemente
- 11 - 18: Öffnung
- 13', 13", 13''': Abschnitt
- 18', 18", 18''': Abschnitt
- 19, 20: Kupferschicht
- 21, 22: Öffnung
- 23: Kühlebene
- 23': Kühlkanal
- 23": Durchlaß
- 24, 24': Schicht
- 25: Kupferplatte
- 26: Ausnehmung
- 27: Keramikeinsatz
- 28, 28': Kupferschicht
- 29: Ausnehmung
- 30: Einsatz aus Diamant oder T-cBN
- 31: Keramikschicht oder -Einsatz
- 32: Kupferschicht
- 33: Schicht
- 34: Kupferplatte
- 35: Modul
- 36: Kühlkörper
- 37: Kupferschichten
- 38: Kühlkanal
- 39, 40: Sammelkanal
- 41, 41', 42: Isolierschicht
- 43, 44, 45: Metallisierung
- 43': Randbereich
- 46,: Isolierschicht
- 48': elektrischer Anschluß
- 48": Isolierung
- 48, 49: Anschluß
- 50: Ringdichtung

## Patentansprüche

1. Diodenlaserbauelement mit einem Kühlkörper sowie mit wenigstens einer an einer Montagefläche des Kühlkörpers vorgesehenen Laserdiodenanordnung (10),
wobei der Kühlkörper als Mehrschichtmaterial aus mehreren in einer Achsrichtung stapelartig übereinander angeordneten und flächig miteinander verbundenen Schichten hergestellt ist,
wobei im Kühlkörper durch Öffnungen in den Schichten von einem Kühlmedium durchströmbare Kühlkanäle, die sich in mehreren in der Achsrichtung gegeneinander versetzten und jeweils von einer Schicht gebildeten Ebenen erstrecken, sowie in diese Kühlkanäle mündende Zu- und Abführkanäle für das Kühlmedium gebildet sind,
wobei die Schichten von Metallschichten (2, 6, 19, 20, 28) und von wenigstens einer den Wärmeausdehnungskoeffizienten des Kühlkörpers reduzierende Schicht (24, 24') gebildet sind, welche aus einem Material mit einem gegenüber den Metallschichten kleineren Wärmeausdehnungskoeffizienten besteht,
wobei die Öffnungen (11, 15, 16, 17, 23', 23", 39 40) ausschließlich in den Metallschichten vorgesehen sind, und
wobei die Anzahl und/oder Dicke der Schichten so gewählt sind, daß der resultierende Wärmeausdehnungskoeffizient zumindest an der Montagefläche an den Wärmeausdehnungskoeffiezienten des Halbleitermaterials der Laserdiodenanordnung (10) angepaßt ist.

2. Diodenlaserbauelement nach Anspruch 1, dadurch gekennzeichnet, daß die den Wärmeausdehnungskoeffizienten des Kühlkörpers reduzierende Schicht (24, 24') eine Metallschicht (25) mit wenigstens einem in eine Öffnung dieser Schicht eingesetzten Einsatz (27) ist, der aus Keramik, vorzugsweise Aluminiumoxid-Keramik oder Aluminiumnitrid-Keramik und/oder aus BeO und/oder aus Diamant und/oder aus T-cBN besteht.

3. Diodenlaserbauelement nach Anspruch 1 oder 2, dadurch gekennzeichnet, daß die wenigstens eine, den Wärmeausdehnungskoeffizienten des Kühlkörpers reduzierende Schicht (24, 24') an der der Diodenanordnung (10) abgewandten Seite einer dieser Laserdiodenanordnung (10) benachbarten Kühlebene (23) vorgesehen ist.

4. Diodenlaserbauelement nach einem der vorhergehenden Ansprüche, daß zur Vermeidung von mechanischen Spannungen in der Laserdiodenanordnung (10) oder in einem diese Anordnung bildenden Chip die wenigstens eine die den Wärmeausdehnungskoeffizienten des Kühlkörpers reduzierende Schicht (24, 24') in der Schichtfolge unter der Montagefläche angeordnet ist, so daß sie den Wärmeausdehnungskoeffizienten des Mehrschicht-Materials (1, 1a, 1b, 1c, 1d) so reduziert, daß dieser zumindest an der Montagefläche kleiner ist als der Wärmeausdehnungskoeffizient des Metalls der Metallschichten und dem Wärmeausdehnungskoeffizienten des Chip-Materials der Laserdiodenanordnung (10) entspricht, und
daß diese wenigstens eine, den Wärmeausdehnungskoeffizienten des Kühlkörpers reduzierende Schicht (24, 24') an der der Laserdiodenanordnung (10) zugewandten Seite der Kühlebene (23) vorgesehen ist und zumindest unter der Montagefläche aus Diamant und/oder T-cBN besteht.

5. Diodenlaserbauelement nach einem der vorhergehenden Ansprüche, dadurch gekennzeichnet, daß das von den Schichten gebildete Mehrschichtmaterial hinsichtlich der Anordnung und/oder Ausbildung der Schichten (2 - 6, 19, 20, 24, 24', 28) symmetrisch oder im wesentlichen symmetrisch zu einer parallel zu den Oberflächenseiten des Substrates verlaufenden Mittelebene (M) ausgebildet ist.

6. Diodenlaserbauelement nach einem der vorhergehenden Ansprüche, dadurch gekennzeichnet, daß in der den Wärmeausdehnungskoeffizienten des Kühlkörpers reduzierende Schicht (24') unmittelbar unterhalb der Montagefläche für die Laserdiodenanordnung (10) oder einer diese Montagefläche bildenden Metallisierung (28) der Einsatz (30) aus Diamant oder T-cBN vorgesehen ist.

7. Diodenlaserbauelement nach einem der vorhergehenden Ansprüche, dadurch gekennzeichnet, daß der Einsatz (27, 30) aus Keramik oder Diamant oder T-cBN eine vergrabene Struktur bildet und vorzugsweise unter einer die Außenfläche des Kühlkörpers oder die Montagefläche bildenden Metallschicht (28) oder Metallisierung angeordnet sind, die beispielsweise von einer Metallfolie oder -platte und/oder von einer galvanisch aufgebrachten Metallschicht gebildet ist.

8. Diodenlaserbauelement nach einem der vorhergehenden Ansprüche, dadurch gekennzeichnet, daß wenigstens ein zum Zuführen oder Abführen des Kühlmediums dienender Durchbruch (23") in der Kühlebene unmittelbar unterhalb der Laserdiodenanordnung (10) vorgesehen ist.

9. Diodenlaserbauelement nach einem der vorhergehenden Ansprüche, dadurch gekennzeichnet, daß die Metallschichten solche aus Kupfer sind.

10. Diodenlaserbauelement nach einem der vorhergehenden Ansprüche, dadurch gekennzeichnet, daß die die wenigstens eine Kühlebene (23) bildenden Schichten Metallschichten sind.

11. Diodenlaserbauelement nach einem der vorhergehenden Ansprüche, dadurch gekennzeichnet, daß zumindest die die wenigstens eine Kühlebene (23) bildenden Schichten und die den Wärmeausdehnungskoeffizienten des Kühlkörpers reduzierende Schicht (24, 24') unter Verwendung der DCB-Technik flächig miteinander verbunden sind.

12. Diodenlaserbauelement nach einem der vorhergehenden Ansprüche, dadurch gekennzeichnet, daß der Einsatz aus Diamant oder T-cBN mittels Aktivlot an einer Fläche der Kühlebene (23) flächig befestigt ist.

13. Diodenlaserbauelement nach Anspruch 12, dadurch gekennzeichnet, daß an dem Einsatz aus Diamant oder T-cBN oder an einer an diesem Einsatz vorgesehene Metallisierung die Laserdiodenanordnung (10) oder eine die Laserdiodenanordnung tragende Metallisierung oder Metallschicht (28) mittels Aktivlot befestigt ist.

14. Diodenlaserbauelement nach einem der vorhergehenden Ansprüche, dadurch gekennzeichnet, daß auf dem Kühlkörper weitere elektrische Bauelemente (8, 9) vorgesehen sind.

15. Diodenlaserbauelement nach einem der vorhergehenden Ansprüche, dadurch gekennzeichnet, daß der Einsatz (30) sich über wenigstens einen größeren Teil der Montagefläche erstreckt, vorzugsweise größer ist als die Montagefläche.

16. Diodenlaserbauelement nach einem der vorhergehenden Ansprüche, dadurch gekennzeichnet, daß sich der Einsatz (30) über die größere Breite der Montagefläche erstreckt, vorzugsweise über eine Länge, die größer ist als die Länge der Montagefläche.

17. Diodenlaserbauelement nach einem der vorhergehenden Ansprüche, dadurch gekennzeichnet, daß der Kühlkörper (36) zumindest in einem Teil (37) aus einem elektrisch leitenden Material besteht, daß die Montagefläche an der Oberseite eine von einer ersten Metallisierung (43) gebildete erste Kontaktfläche für die Laserdiodenanordnung (10) ist, daß der Kühlkörper (36) oder dessen Teil (37) aus elektrisch leitendem Material durch eine erste Isolierschicht (41) elektrisch von der ersten Metallisierung (43) getrennt ist, und daß auf die Unterseite des Kühlkörpers (36) aus elektrisch leitendem Material eine zweite Isolierschicht (42) und auf diese eine zweite Metallisierung (44) aufgebracht ist, und daß die erste Metallisierung (43) und die zweite Metallisierung (44) miteinander über eine Verbindung (47) elektrisch verbunden sind, die ebenfalls von dem elektrisch leitenden Teil (37) des Kühlkörpers (36) elektrisch isoliert ist.

18. Diodenlaserbauelement nach Anspruch 17, dadurch gekennzeichnet, daß die Verbindung von wenigstens einer Durchkontaktierung (47), die isoliert durch den elektrischen Teil (37) des Kühlkörpers (36) hindurchgeführt ist, und/oder dadurch gebildet ist, daß die erste und zweite Metallisierung (43, 44) über einen über einen Randbereich des Kühlkörpers (36) geführten elektrisch leitenden Bereich (43') miteinander verbunden sind.

19. Diodenlaserbauelement nach Anspruch 17 oder 18, dadurch gekennzeichnet, daß auf der Oberseite des Elementes (1e) eine dritte Metallisierung (45) vorgesehen ist, die einen zweiten elektrischen Anschluß für die Laserdiodenanordnung (10) bildet und vorzugsweise von einer aufgelöteten Metall- oder Kupfer-Folie gebildet ist.

20. Diodenlaserbauelement nach einem der vorhergehenden Ansprüche, dadurch gekennzeichnet, daß die das Kühlelement bildende Schichtfolge symmetrisch zu der zu den Oberflächenseiten des Kühlelements verlaufenden Mittelebene ausgebildet ist.

## Claims

1. Diode laser component with cooling element, as well as at least one laser diode arrangement (10) provided on a mounting surface of the cooling body, with the cooling body being produced as a multi-layer material of several layers stacked on top of one another in an axial direction and being connected to one another over their entire surfaces,
with cooling channels through which a coolant can flow being formed in the cooling body, by means of openings in the layers, these channels extending in several levels that are offset relative to one another in the axial direction and are in each case formed by one layer, and with inlet and outlet channels for the coolant opening into these cooling channels,
with the layers being formed of metal layers (2, 6, 19, 20, 28) and by at least one layer (24, 24') that reduces the thermal expansion coefficient of the cooling body, this layer being of a material with a thermal expansion coefficient that is smaller than that of the metal layers,
with the openings (11, 15, 16, 17, 23' 23'', 39, 40) being provided exclusively in the metal layers, and
with the number and/or thickness of the layers being selected such that at least on the mounting surface, the resulting thermal expansion coefficient is adapted to the thermal expansion coefficient of the semi-conductor material of the laser diode arrangement (10).

2. Diode laser component in accordance with claim 1, characterised in that the layer (24, 24') that reduces the thermal expansion coefficient of the cooling body is a metal layer (25) with at least one insert (27) that is placed in an opening in this layer, this insert being of ceramic, preferably aluminium dioxide ceramic or aluminium nitride ceramic and/or of BeO and/or of diamond and/or of T-cBN.

3. Diode laser component in accordance with claim 1 or 2, characterised in that the at least one layer (24, 24') that reduces the thermal expansion coefficient of the cooling body is provided on that side of a cooling plane (23), adjacent to this laser diode arrangement (10), that faces away from the diode arrangement (10).

4. Diode laser component in accordance with one of the preceding claims, that for the avoidance of mechanical stresses in the laser diode arrangement (10) or in a chip forming this arrangement, the at least one layer (24, 24') that reduces the thermal expansion coefficient of the cooling body is arranged in the layer sequence below the mounting surface in such a way that it reduces the thermal expansion coefficient of the multi-layer material (1, 1a, 1b, 1c, 1d) such that at least on the mounting surface, it is smaller than the thermal expansion coefficient of the metal of the metal layers, and corresponds to the thermal expansion coefficient of the chip material of the laser diode arrangement (10), and
that this at least one layer (24, 24') that reduces the thermal expansion coefficient of the cooling body is provided on that side of the cooling plane (23) facing the laser diode arrangement (10), and is of diamond and/or T-cBN at least below the mounting surface.

5. Diode laser component in accordance with one of the preceding claims, characterised in that the multi-layer material formed of the layers is, in respect of the arrangement and/or formation of the layers (2-6, 19, 20, 24, 24', 28), designed to be symmetrical or essentially symmetrical to a central plane (M) running parallel to the surfaces of the substrate.

6. Diode laser component in accordance with one of the preceding claims, characterised in that in the layer (24') that reduces the thermal expansion coefficient of the cooling body, immediately below the mounting surface for the laser diode arrangement (10) or a metallisation (28) forming this mounting surface, the insert (30) of diamond or T-cBN is provided.

7. Diode laser component in accordance with one of the preceding claims, characterised in that the insert (27, 30) of ceramic or diamond or T-cBN forms a buried structure, and is preferably arranged below a metal layer (28) or metallisation forming the outer face of the cooling body of the mounting surface, which for example is formed of a metal foil or metal plate, and/or formed by a galvanically applied metal layer.

8. Diode laser component in accordance with one of the preceding claims, characterised in that at least one opening (23"), that serves to let coolant in or out, is provided in the cooling plane immediately below the laser diode arrangement (10).

9. Diode laser component in accordance with one of the preceding claims, characterised in that the metal layers are of copper.

10. Diode laser component in accordance with one of the preceding claims, characterised in that the layers that form at least one cooling plane (23) are metal layers.

11. Diode laser component in accordance with one of the preceding claims, characterised in that at least the layers that form at least one cooling plane (23), and the layer (24, 24') that reduces the thermal expansion coefficient of the cooling body, are connected with one another over their entire surfaces using the DCB technique.

12. Diode laser component in accordance with one of the preceding claims, characterised in that the insert of diamond or T-cBN is fixed, over the entire surface, to one surface of the cooling plane (23) by means of active solder.

13. Diode laser component in accordance with claim 12, characterised in that on the insert of diamond or T-cBN, or on a metallisation provided on this insert, the laser diode arrangement (10), or a metallisation or metal layer (28) bearing the laser diode arrangement, is fixed by means of active solder.

14. Diode laser component in accordance with one of the preceding claims, characterised in that further electrical components (8, 9) are provided on the cooling body.

15. Diode laser component in accordance with one of the preceding claims, characterised in that the insert (30) extends over at least a greater part of the mounting surface, [that] is preferably larger than the mounting surface.

16. Diode laser component in accordance with one of the preceding claims, characterised in that the insert (30) extends over at least the greater width of the mounting surface, preferably over a length that is greater than the length of the mounting surface.

17. Diode laser component in accordance with one of the preceding claims, characterised in that the cooling body (36), at least in one part (37), is of an electrically conductive material; that the mounting surface on the surface is a first contact face, formed by a first metallisation (43), for the laser diode arrangement (10); that the cooling body (36), or its part (37), made of electrically conductive material is electrically separated from the first metallisation (43) by a first insulating layer (41); and that a second insulating later (42) is applied on the underside of the cooling body (36) made of electrically conductive material, and on it in turn a second metallisation (44) is applied; and that the first metallisation (43) and the second metallisation (44) are electrically connected with one another via a connection (47) which is likewise electrically insulated from the electrically conductive part (37) of the cooling body (36).

18. Diode laser component in accordance with claim 17, characterised in that the connection is formed by at least one through-plating (47) which is passed, insulated, through the electrical part (37) of the cooling body (36), and/or by the fact that the first and second metallisations (43, 44) are connected with one another via an electrically conductive area (43') that extends across an edge zone of the cooling body (36).

19. Diode laser component in accordance claim 17 or 18, characterised in that provided on the surface of the element (1e) is a third metallisation (45) that forms a second electrical connection for the laser diode arrangement (10), and is preferably formed by a soldered-on metal or copper foil.

20. Diode laser component in accordance with one of the preceding claims, characterised in that the sequence of layers forming the cooling element is designed to be symmetrical to the central plane that runs [*omission*] to the surfaces of the cooling plane.

## Revendications

1. Composant à diode laser avec élément de refroidissement et avec au moins un emplacement pour diode laser prévu sur une des surfaces de montage de l'élément de refroidissement,
l'élément de refroidissement ayant la forme d'un corps composé de plusieurs couches empilées les unes sur les autres, dans un sens, et reliées par leurs faces, dans lequel élément sont formés des canaux de refroidissement parcourus par un agent réfrigérant qui s'étendent dans plusieurs plans décalés dans un sens l'un par rapport à l'autre, au même titre que les canaux d'arrivée et d'évacuation débouchait dans les canaux de refroidissement pour l'agent réfrigérant, grâce à des ouvertures dans les différentes couches,
les couches étant constituées de couches métalliques (2, 6, 19, 20, 28) et d'au moins une couche (24, 24') réduisant le coefficient de dilatation thermique, formée à partir d'un matériau avec un coefficient de dilatation thermique inférieur à celui des couches métalliques,
les ouvertures (11, 15, 16, 17, 23', 23'', 39, 40) étant prévues uniquement dans les couches métalliques, et
le nombre et / ou l'épaisseur des couches étant choisis de telle sorte que le coefficient de dilatation thermique final soit, au moins sur la surface de montage, adapté au coefficient de dilatation thermique du matériau semi-conducteur de l'emplacement pour diode laser (10).

2. Elément à diode laser selon la revendication 1, caractérisé en ce que la couche (24, 24') réduisant le coefficient de dilatation thermique de l'agent réfrigérant consiste en une couche métallique (25) avec au moins une insertion dans une ouverture de cette couche, l'insertion étant en céramique, de préférence un mélange céramique - oxyde d'aluminium, céramique - nitrure d'aluminium et / ou en BeO et / ou en diamant et / ou en T-cBN.

3. Composant à diode laser selon la revendication 1 ou 2, caractérisé en ce que au moins la couche (24, 24') réduisant le coefficient de dilatation thermique de l'agent réfrigérant est prévue sur le côté détourné de l'emplacement pour diode laser (10) d'un des plans de refroidissement (23) voisins de l'emplacement pour diode laser (10).

4. Composant à diode laser selon une des revendications précédentes, caractérisé en ce que, pour éviter des tensions mécaniques à l'emplacement pour diode laser (10) ou dans un microprocesseur constituant cet emplacement, au moins la couche (24, 24') réduisant le coefficient de dilatation thermique de l'agent réfrigérant est disposée dans la suite de couches, sous la surface de montage, de telle sorte que le coefficient de dilatation thermique du matériau multicouche (1, 1a, 1b, 1c, 1d) soit, au moins sur la surface de montage, inférieur au coefficient de dilatation thermique du métal des couches métalliques et équivalent au coefficient de dilatation du matériau du microprocesseur de l'emplacement pour diode laser (10) et
caractérisé en ce que au moins la couche (24, 24') réduisant le coefficient de dilatation thermique de l'agent réfrigérant est prévue sur le côté du plan de refroidissement (23) tourné vers l'emplacement pour diodes laser (10) et est constituée, au moins sous la surface de montage, de diamant et/ou de T-cBN.

5. Composant à diode laser selon l'une ou l'autre des revendications précédentes, caractérisé en ce que les couches (2 - 6, 19, 20, 24) qui constituent le matériau multicouche sont disposées et/ou formées de telle sorte que ce matériau soit symétrique ou essentiellement symétrique par rapport à un plan central (M) s'étendant parallèlement aux côtés superficiels du substrat.

6. Composant à diode laser selon l'une ou l'autre des revendications précédentes, caractérisé en ce que l'insertion (30) en diamant ou T-CBN est prévue dans la couche (24') réduisant le coefficient de dilatation thermique de l'agent réfrigérant, directement sous la surface de montage destinée à l'emplacement pour diode laser (10) ou sous une métallisation (28) constituant cette surface de montage.

7. Composant à diode laser selon l'une ou l'autre des revendications précédentes, caractérisé en ce que l'insertion (27, 30) en céramique, diamant ou T-cBN forme une structure enfoncée et est disposée de préférence sous une couche métallique (28) ou une métallisation formant la surface externe de l'agent réfrigérant ou la surface de montage, la métallisation étant constituée par exemple d'une feuille ou d'une plaque de métal et/ou d'une couche métallique appliquée par galvanisation.

8. Composant à diode laser selon l'une ou l'autre des revendications précédentes, caractérisé en ce que au moins une ouverture (23'') servant à amener ou évacuer l'agent réfrigérant est prévue dans le plan de refroidissement, directement sous l'emplacement pour diode laser (10).

9. Composant à diode laser selon l'une ou l'autre des revendications précédentes, caractérisé en ce que les couches métalliques sont constituées de cuivre.

10. Composant à diode laser selon l'une ou l'autre des revendications précédentes, caractérisé en ce que les couches formant au moins un plan de refroidissement (23) sont des couches métalliques.

11. Composant à diode laser selon l'une ou l'autre des revendications précédentes, caractérisé en ce que au moins les couches formant au moins un plan de refroidissement (23) et la couche (24, 24') réduisant le coefficient de dilatation thermique de l'agent réfrigérant sont reliées superficiellement les unes aux autres, en utilisant la technique DCB.

12. Composant à diode laser selon l'une ou l'autre des revendications précédentes, caractérisé en ce que l'insertion en diamant ou T-cBN est fixée superficiellement à une surface du plan de refroidissement (23) par une soudure active.

13. Composant à diode laser selon la revendication 12, caractérisé en ce que l'emplacement pour diode laser (10) ou une métallisation ou couche métallique (28) supportant l'emplacement pour diode laser sont fixés par soudure active à l'insertion en diamant ou T-cBN ou à une métallisation prévue sur cette insertion.

14. Composant à diode laser selon l'une ou l'autre des revendications précédentes, caractérisé en ce que d'autres éléments structuraux (8, 9) électriques sont prévus sur l'agent réfrigérant.

15. Composant à diode laser selon l'une ou l'autre des revendications précédentes, caractérisé en ce que l'insertion (30) s'étend au moins sur une grande partie de la surface de montage et est si possible plus grande que cette même surface de montage.

16. Composant à diode laser selon l'une ou l'autre des revendications précédentes, caractérisé en ce que l'insertion (30) s'étend sur la plus grande largeur de la surface de montage et de préférence sur une longueur supérieure à celle de la surface de montage.

17. Composant à diode laser selon l'une ou l'autre des revendications précédentes, caractérisé en ce que l'agent réfrigérant (36) consiste, dans une partie (37) au moins, en un matériau électro-conducteur, en ce que la surface de montage sur le côté supérieur constitue une première surface de contact pour l'emplacement pour diode laser (10), formée par une première métallisation (43), en ce que l'agent réfrigérant (36) ou sa partie (37) qui consiste en un matériau électro-conducteur sont séparés électriquement de la première métallisation (43) par une première couche isolante (41), en ce que une deuxième métallisation (44) est appliquée sur une deuxième couche isolante (42) elle-même appliquée sur la face inférieure de l'agent réfrigérant (36) composé d'un matériau électro-conducteur, et en ce que la première (43) et la deuxième métallisation (44) sont reliées l'une à l'autre par une liaison (47) électrique isolée électriquement par rapport à la partie électro-conductrice (37) de l'agent réfrigérant (36).

18. Composant à diode laser selon la revendication 17, caractérisé en ce que la liaison est formée en procédant au moins à une métallisation des trous (47) isolée dans la partie électro-conductrice (37) de l'agent réfrigérant (36) et/ou en reliant la première et la deuxième métallisation (43, 44) par l'intermédiaire d'une zone électro-conductrice (43') guidée au-delà d'une zone marginale de l'agent réfrigérant (36).

19. Composant à diode laser selon la revendicatic.. 17 ou 18, caractérisé en ce que une troisième métallisation (45) formant un deuxième raccordement électrique pour l'emplacement pour diode laser (10) et constituée de préférence par une feuille dessoudée en métal ou en cuivre a été prévue sur le côté supérieur du composant (1e).

20. Composant à diode laser selon l'une ou l'autre des revendications précédentes, caractérisé en ce que la suite de couches qui constitue l'élément de refroidissement a été configurée de manière symétrique par rapport au plan central s'étendant vers les côtés superficiels de l'élément de refroidissement.
